# EUROPÄISCHE PATENTSCHRIFT

(11) **EP 3 303 259 B1**
(45) Veröffentlichungstag und Bekanntmachung des Hinweises auf die Patenterteilung: **31.07.2019**
(21) Anmeldenummer: 16724610.7
(22) Anmeldetag: 13.05.2016
(51) Int. Cl.: C04B 37/02

(54) **VERFAHREN ZUR HERSTELLUNG EINES VERBUNDMATERIALS**
METHOD FOR PRODUCING A COMPOSITE MATERIAL
PROCÉDÉ DE FABRICATION D'UN MATÉRIAU COMPOSITE

(30) Priorität: 02.06.2015 DE 102015108668
(43) Veröffentlichungstag der Anmeldung: 11.04.2018
(73) Patentinhaber: Rogers Germany GmbH, 92676 Eschenbach (DE)
(72) Erfinder: MEYER, Andreas, 93173 Wenzenbach (DE); BRITTING, Stefan, 91220 Schnaittach (DE); KNÖCHEL, Dieter, 95488 Eckersdorf (DE); BIERWAGEN, David, 91220 Schnaittach (DE)
(74) Vertreter: Müller Schupfner & Partner Patent- und Rechtsanwaltspartnerschaft mbB
(86) Internationale Anmeldenummer: PCT/EP2016/060896
(87) Internationale Veröffentlichungsnummer: WO 2016/192965

(56) Entgegenhaltungen:
- WO-A1-2014/136683
- WO-A1-2015/046280
- WO-A2-01/86715
- WO-A2-2009/140709
- DE-A1-102005 029 246
- JP-A- 2001 203 299
- US-A1- 2010 032 143

## Beschreibung

Die vorliegende Erfindung betrifft ein Verfahren zur Herstellung eines Verbundmaterials, insbesondere einer Leiterplatte, sowie ein Verbundmaterial.

Verbundmaterialien wie Leiterplatten mit Zusatzschichten in Form von Metallisierungen, die auf einem keramischen Basismaterial angeordnet sind, sind aus dem Stand der Technik in den verschiedensten Ausführungen bekannt und werden für Zwecke der Leistungselektronik eingesetzt. Weiterhin ist zur Befestigung der Zusatzschicht auf dem Basismaterial, beispielsweise aus der DE 22 13 115, das Aktivlot-Verfahren bekannt. Bei diesem Verfahren, welches speziell auch zum Herstellen von Metall-Keramik-Substraten verwendet wird, wird unter Verwendung eines entsprechenden Lotmaterials bei einer Temperatur von 650 bis 1000 °C eine kraftschlüssige Verbindung zwischen einer Metallfolie, beispielsweise einer Kupferfolie, und einem Keramiksubstrat, beispielsweise einer Aluminiumnitrid-Keramik, hergestellt. Das Lotmaterial enthält zusätzlich zu einer Hauptkomponente wie Kupfer, Silber und/oder Gold auch ein Aktivmetall. Dieses Aktivmetall, welches beispielsweise wenigstens ein Element der Gruppe Hf, Ti, Zr, Nb oder Ce ist, stellt durch chemische Reaktion eine Verbindung zwischen dem Lot und der Keramik her, während die Verbindung zwischen dem Lot und dem Metall eine metallische Hartlöt-Verbindung ist.

Im Lötprozess bildet das Aktivelement eine Reaktionsschicht mit der Keramik, die von den anderen Lotelementen im Lötprozess benetzt werden kann. Üblicherweise werden Aktivlote als Paste, in der das Aktivelement als Partikel vorliegt, im Siedruckverfahren auf die zu lötenden Fügepartner an den Stellen aufgebracht, an denen die Verbindung angedacht ist. Die Geometrie der Reaktionsschicht, die sich dabei ergibt, führt allerdings zu Substraten/Verbundmaterialien, die hinsichtlich ihrer thermischen und mechanischen Eigenschaften nicht optimal sind. Zudem ist das Verfahren aufgrund des hohen Silberverbrauchs vergleichsweise teuer. Daneben ist auch die Verwendung gewalzter Lotbänder mit einer Aktivlotzusammensetzung bekannt, die allerdings ebenfalls nicht geeignet sind, die vorgenannten Nachteile zu beseitigen, da auch hier eine optimale Ausbildung der Reaktionsschicht nicht möglich ist.

JP 2001 203299 A offenbart eine Verbindung einer AlN-Leiterplatte mit einer Aluminiumplatte mittels einer Lotschicht mit einer Dicke von 10 Mikron.

Es ist daher eine Aufgabe der vorliegenden Erfindung, ein Verfahren zur Herstellung eines Verbundmaterials, insbesondere einer Leiterplatte, sowie ein Verbundmaterial, anzugeben, welches mechanisch wie thermisch höchst belastbar und günstiger ist.

Diese Aufgabe wird durch ein Verfahren zur Herstellung eines Verbundmaterials, insbesondere einer Leiterplatte, gemäß Anspruch 1 sowie durch ein Verbundmaterial gemäß Anspruch 9 gelöst. Weitere Vorteile und Merkmale der Erfindung ergeben sich aus den Unteransprüchen sowie der Beschreibung und den beigefügten Figuren.

Erfindungsgemäß ist ein Verfahren zur Herstellung eines Verbundmaterials, insbesondere einer Leiterplatte vorgesehen, wobei das Verbundmaterial ein flächiges Basismaterial, insbesondere eine Keramik, aufweist, an welcher ein- oder beidseitig mittels einer Lotschicht eine Zusatzschicht, insbesondere eine Metallisierung, angebracht wird, und wobei das Verfahren durch folgende Schritte gekennzeichnet ist:
- Bereitstellen des Basismaterials, wobei das Basismaterial auf mindestens einer Seite eine erste Oberfläche aufweist;
- Bereitstellen der Zusatzschicht und Anordnen der Lotschicht zwischen einer zweiten Oberfläche der Zusatzschicht und der ersten Oberfläche derart, insbesondere durch Aufbringen der Lotschicht auf zumindest einer zweiten Oberfläche der Zusatzschicht, dass beim Auflegen der Zusatzschicht auf die erste Oberfläche die erste Oberfläche des Basismaterials flächig, insbesondere vollflächig, mit der Lotschicht bedeckt ist, wobei eine Dicke der Lotschicht zwischen dem Basismaterial und der Zusatzschicht kleiner als 12 µm, insbesondere kleiner als 7 µm, ist;
- Erhitzen des Basismaterials und der auf der ersten Oberfläche angeordneten Zusatzschicht zum zumindest teilweisen Schmelzen der Lotschicht und Verbinden des Materials mit der mindestens einen Zusatzschicht.

Die flächige, insbesondere vollflächige, Bedeckung der ersten Oberfläche des Basismaterials mit der Lotschicht unterscheidet sich deutlich von dem bekannten Vorgehen beim Siebdruckverfahren oder vom Auflegen von schmalen Lotbändern in mehreren Bahnen. Dabei sei darauf hingewiesen, dass "vollflächig" auch meint, dass bei dem Basismaterial beispielsweise ein kleiner Rand bleibt, welcher keine Lotschicht aufweist, wobei dieser Rand bis zu mehrere Millimeter beispielweise 2, 3, 5 oder 6 mm betragen kann. Vollflächig ist als Abgrenzung zu einem nur punktuellen oder teilweisen/abschnittsweisen Aufbringen der Lotschicht zu verstehen und so auszulegen, dass eine vollflächige Bedeckung auch dann noch vorliegt, wenn ein kleiner Teil oder kleinere Abschnitte/Bereiche der ersten Oberfläche, aus welchen Gründen auch immer, nicht bedeckt sein sollten.

Beim Siebdruckverfahren wird z. B. nur punktweise bzw. in kleinen Flächen oder Abschnitten die Paste/Lotschicht aufgebracht, was allein aufgrund der Materialkosten das Verfahren unnötig verteuert, da verfahrensbedingt regelmäßig zu hohe bzw. dicke Lotschichten aufgetragen werden. Zudem können aufgrund der hier auftretenden dicken Lotschichten mechanisch weniger gute Ergebnisse erzielt werden. Das Aufbringen von Lotbändern, wie sie aus dem Stand der Technik bekannt sind, erfolgt in der Regel bahnweise und gerade nicht flächig, insbesondere nicht vollflächig, auf das Basismaterial. Das Aufbringen von Lotbändern ist zudem aufwendig, da sehr exakt darauf geachtet werden muss, dass die Bahnen/Lotbänder genau nebeneinander liegen. Überlappen sich die Lotschichtbahnen, führt dies punktuell bzw. abschnittsweise zu einer viel zu dicken Lotschicht und zu entsprechend schlechten mechanischen Eigenschaften. Ist zwischen den aufgetragenen Lotbahnen ein Spalt vorhanden, kann die Benetzung darunter leiden und es kann zu regelrechten Fehlstellen in der Lotschicht und der späteren Kontaktierung kommen.

Abhilfe schafft die hier vorgeschlagene flächige, insbesondere vollflächige, Bedeckung des Basismaterials, welches in einer Ausführungsform eine in etwa rechteckige Form mit einer Seitenlänge von ca. 7,5 x 11,5 Zoll aufweist. Eine Dicke des Basismaterials liegt in einer Ausführungsform in einem Bereich von 0,1 - 2,5 mm, bevorzugt zwischen 0,2 und 1 mm.

In einer Ausführungsform weist das Basismaterial AIN, Si3N4, SiC, Al2O3, ZrO2, ZTA (Zirconia Toughened Aluminum Oxide, Zirconiumdioxid-verstärktes Aluminiumoxid), BeO, TiO2, HPS, HPI und/oder TiOx auf bzw. besteht aus einem oder einer Kombination der vorgenannten Stoffe/Materialien. HPS Substrate werden mit zirkondotierter Al2O3 Keramik hergestellt. Sie sind robust und werden hauptsächlich im mittleren Leistungsbereich eingesetzt. Die Verwendung von hier nicht explizit erwähnten anderen Keramiken ist aber genauso möglich.

In einer Ausführungsform weist die Zusatzschicht Cu, eine Cu-Legierung, Mo, W, Ta, Nb, Ni, Fe, Al, eine Aluminiumlegierung, Stahl und/oder eine Ti-Legierung auf bzw. besteht aus einem oder einer Kombination der vorgenannten Stoffe/Materialien. Eine Dicke der Zusatzschicht liegt in einer Ausführungsform in einem Bereich von etwa 0,1 - 1 mm, bevorzugt in einem Bereich von 0,2 - 0,8 mm.

Um Verbundmaterialien mit bestmöglichen mechanischen (z. B. hinsichtlich Temperaturwechselbeständigkeit, Abzugs- und Scherfestigkeit) sowie thermischen Eigenschaften bereitzustellen, welche z. B. eine gute Wärmeableitung in leistungselektronischen Modulen ermöglichen, wird die Lotschicht beim Aktivlotverfahren (AMB, Active Metall Brazing) so ausgebildet, dass eine Reaktionsschicht entsprechender Dicke auf dem Basismaterial erreicht wird. Bevorzugt ist eine Dicke der Reaktionsschicht von etwa 0,01 bis 10 µm, insbesondere bevorzugt eine Dicke von etwa 0,05 bis 1 µm.

Die Dicke der Reaktionsschicht ist maßgeblich für die mechanische Stabilität des Substrates/des Verbundmaterials verantwortlich, d. h. je dünner diese Reaktionsschicht ist, desto besser werden die Eigenschaften des Verbundmaterials in Bezug auf Temperaturwechselbeständigkeit und Abzugs- bzw. Scherfestigkeit. Dies liegt an der Sprödigkeit der sich ausbildenden Reaktionsschicht, z. B. TiN. Des Weiteren bleibt ein gewisser Anteil des Aktivelements in der Lotschicht zurück und bildet beim Abkühlen nach der eigentlichen Lötung intermetallische Phasen, wie z. B. CuTi oder AgTi, die ihrerseits mit einer gewissen Sprödigkeit die Duktilität der Lotschicht beeinträchtigen.

Um homogene Reaktionsschichten in den gewünschten Dicken/Stärken zu ermöglichen, wird vorgeschlagen, die Dicke der Lotschicht auf weniger als 7 µm zu reduzieren. Ein bevorzugter Bereich der Dicke/Schichtdicke der Lotschicht liegt etwa zwischen 2 und 5 µm.

Um eine dünne Reaktionsschicht zu erzeugen, könnte grundsätzlich auch ein geringerer Gehalt an Aktivelementen in die beispielsweise beim Siebdruckverfahren verwendete Paste eingebracht werden, wodurch aber die gleichmäßige Verteilung des Aktivelements ausgehend von Partikeln und somit die homogene Bildung einer Reaktionsschicht nicht mehr gegeben wäre. Zudem ist die Herstellung der hierfür notwendigen sehr kleinen Partikel bei gleichzeitig homogener Korngrößenverteilung technisch nur sehr schwer und unter großem Kosteneinsatz möglich. Der Grund hierfür liegt im Fall der beschriebenen Verbundmaterialien/Substrate in einer zeitlichen Begrenzung des flüssigen Zustands des Lotes bei gegebener Heißhaltetemperatur im Lötprozess, da fortwährend im Falle z. B. einer Kupfermetallisierung Kupfer im Lot gelöst werden würde, wodurch die Solidustemperatur der vorliegenden Schmelze steigt.

Durch die Verringerung der Lotschichtdicke auf das angegebene Maß von weniger als 7 µm, wird genau die Menge an Aktivelement auf die Fläche verteilt bereitgestellt, die beim Lötvorgang umgesetzt werden muss, um eine homogene Reaktionsschicht zu erzeugen, die dauerhaft und stabil ist.

In einer Ausführungsform ist die Lotschicht eine Aktivlotschicht, die Lotmaterial bzw. Lotelemente, insbesondere Ag, Cu, Sn, Zn und/oder In bzw. eine Kombination der vorgenannten Materialien aufweist. Desweiteren weist die Lotschicht Aktivmaterial bzw. Aktivelemente, insbesondere Ti, Tr, Hf, Cr, Y, Nb und/oder V auf. Die Aktivlot-Legierung bzw. die Lotschicht besteht in einer Ausführungsform aus den Metallen Silber, Kupfer, Indium und Titan. Das Lot schmilzt durch einen durch das Verhältnis Kupfer zu Silber erniedrigten Schmelzpunkt. Je nach Anwendung könnten beide Metalle in beliebigem Verhältnis zueinander im Lot vorkommen, was aber einen direkten Einfluss auf die Lottemperatur hat. Indium (In) oder Zinn (Sn) (0 - 15 wt%) im Lot vergrößert den Arbeitsbereich/Schmelzbereich des Lotes zu tieferen Temperaturen als das Ag-Cu-Gemisch zulässt. Zudem verbessert das Indium die Benetzung von Oberflächen, welche am Verbund beteiligt sind. Das Titan kann als Aktivelement durch andere Elemente (Metalle) ersetzt werden, die als Aktivelement fungieren. In erster Linie sind dies Zr und Hf. Aber auch Y, V, Zr, Nb können als Aktivelemente eingesetzt werden, wobei deren Aktivierungstemperatur weit oberhalb derer von Titan liegt. Der Gehalt an Titan ist an die zu verbindenden Oberflächen anzupassen und liegt im Normalfall zwischen 1 und 10 Gewichtsprozent.

Bei einer Reaktionsschichtdicke von 0,01 µm beträgt in einer Ausführungsform das spezifische Gewicht von TiN etwa 5,21 µg/cm². Bei einer Reaktionsschichtdicke von 0,05 µm beträgt in einer Ausführungsform das spezifische Gewicht von TiN etwa 26,05 µg/cm². Bei einer Reaktionsschichtdicke von 1 µm beträgt in einer Ausführungsform das spezifische Gewicht von TiN etwa 521 µg/cm². Bei einer Reaktionsschichtdicke von 10 µm beträgt in einer Ausführungsform das spezifische Gewicht von TiN etwa 5210 µg/cm².

Zweckmäßigerweise ist die Zusammensetzung der gesamten Lotschicht/Lotlegierung so gewählt, dass bei Löttemperatur, welche im Bereich von etwa 600 - 700°C (ggf. auch höher) liegt, die Zusatzschicht/Metallisierungsschicht von der aufgebrachten Lotschicht nur angeschmolzen (z. B. bei Kupfer) oder benetzt wird und das enthaltene Aktivelement gänzlich von der Lotschmelze gelöst wird, so dass es bei Lottemperatur mit dem zu fügenden Partner reagieren kann. Der Lötprozess kann unter Verwendung geeigneter Öfen sowohl in einem Stapelprozess als auch in Durchlauföfen durchgeführt werden.

Unabhängig von der Schichtdicke muss die Lotschicht über das ganze Volumen im Bereich der Löttemperatur erhitzt werden. Gemäß einer Ausführungsform beträgt die Löttemperatur etwa 650 bis 1000 °C, vorzugsweise etwa 700 bis 950 °C, wobei mit Löttemperatur die Temperatur in der Lotschicht gemeint ist. Zweckmäßigerweise wird eine möglichst geringe Löttemperatur angestrebt.

Eine Dicke der Lotschicht beträgt in einer Ausführungsform ca. 10 bis 30 µm, vorzugsweise aber weniger als ca. 7 bis 12 µm, beispielsweise etwa 2 bis 10 µm bzw. bevorzugt 2 bis 5 µm.

Eine Heißhaltezeit beträgt gemäß einer Ausführungsform etwa 10 bis 180 min, eine Lötzeit ca. 5 bis 160 min. Dabei meint die Heißhaltezeit die eingestellte Temperatur am Ofen. Analog wäre die Heißhaltetemperatur die eingestellte Temperatur am Ofen. Die Löttemperatur bzw. Lötzeit ist die Temperatur und Zeit in der Lotschicht. Mögliche Atmosphären, unter welchen der Lötprozess stattfinden kann umfassen oder bestehen aus Argon, Stickstoff und/oder Helium.

Mögliche Ofenarten sind gemäß einer Ausführungsform widerstandsbeheizte Vakuumöfen mit Graphitheizer oder Metallheizer. Möglich ist auch die Verwendung von widerstandsbeheizten Inertgas-Öfen als Durchlauföfen oder auch als Chargenöfen. Gemäß einer Ausführungsform ist auch ein induktionsbeheizter Intergas-Ofen als Chargenofen vorgesehen. In einer anderen Ausführungsform ist eine Heißpresse mit Inertgas oder Vakuum vorgesehen oder eine heißisostatische Presse mit gekapselten Laminaten.

Mögliche Lotschichtzusammensetzungen setzen sich wie folgt zusammen:
Eine ideale eutektische und bevorzugte Zusammensetzung umfasst beispielsweise 65-75 wt% Silber (Ag) und 25-35 wt% Kupfer (Cu). In einer Ausführungsform, bei Löttemperaturen bis 900 °C, reichen die Bereiche auch von 40-95 wt% Silber (Ag) und 5-60 wt% Kupfer (Cu).

Ein bevorzugtes Aktivelement ist Titan. Ebenso sind Cr, V, Nb, Y, Ta, Zr und/oder Hf verwendbar. Der Anteil liegt hier bei 0,5-10 wt%, vorzugweise bei 1-5 wt%. Als Additivelemente werden Sn und/oder In verwendet, bei einem Anteil von 0 bis 15 wt%, bevorzugt etwa 1 bis 10 wt%. Es kann gemäß einer Ausführungsform also auch auf das Additivelement verzichtet werden,
Die Zusammensetzung der Lotschicht bzw. des Lotmaterials/der Lotlegierung ist zweckmäßigerweise so gewählt, dass sie beispielsweise sowohl für das Aufbringen auf die zweite Oberfläche, beispielsweise für das Walzplattieren, geeignet ist als auch für den späteren Lötprozess. Allgemeiner ausgedrückt erfüllt die Lotschicht bzw. deren Legierungszusammensetzung den Zweck des Aktivlötens für die Anwendung in AMB-Substraten und kann gleichzeitig in einem Walzplattierprozess.

Ein weiterer Vorteil der dünnen Lotschicht liegt in der besseren Wärmeleitfähigkeit eines derartigen Verbundmaterials. So weist eine Lotschicht der in Rede stehenden Art eine schlechtere Wärmeleitfähigkeit auf (ca. 70 W/mK) als das entsprechende Reinelement, wie z. B. Cu (390 W/mK) oder Ag (429 W/mK). Dieser Aspekt ist insbesondere von Bedeutung, als es ein entscheidendes Ziel ist, ein Verbundmaterial mit einer guten Wärmeableitung zur Verwendung in leistungselektronischen Modulen bereitzustellen.

In einer Ausführungsform des Verfahrens erfolgt das Aufbringen der Lotschicht auf die zweite Oberfläche der Zusatzschicht durch Walzplattieren. Beim Walzplattieren wird die Lotschicht auf ein Träger unter Druck und Wärme aufgewalzt. Dabei entsteht eine unlösbare Verbindung durch Diffusion und Pressschweißung.

Beim Walzplattieren kann das Lotmaterial/die Lotschicht gemäß einer Ausführungsform entweder einseitig direkt auf die Zusatzschicht oder beidseitig auf ein Trägermaterial, wie eine separate Metallfolie (z. B Cu), aufgebracht werden. Hierdurch sind deutlich dünnere Lotschichten als bei einem reinen gewalzten Lotband (ohne Trägermaterial) möglich. Wenn von der "Dicke" der Lotschicht die Rede ist, ist bei zweiseitig beschichteten Trägermaterialien eine "Gesamtdicke" gemeint.

In einer Ausführungsform wird die Lotschicht also auf einem Trägermaterial bereitgestellt, bevor sie auf zumindest eine zweite Oberfläche der Zusatzschicht oder auch auf die erste Oberfläche des Basismaterials aufgebracht wird. Bei dem Trägermaterial handelt es sich beispielsweise um die separate (Metall-)Folie, beispielsweise aus Kupfer, welche derart ausgebildet ist, dass sie die Lotschicht tragen, halten und/oder stützen kann. Mit anderen Worten muss das Trägermaterial sozusagen das Handling der Lotschicht ermöglichen. Zweckmäßigerweise ist eine derart auf einem Trägermaterial fixierte Lotschicht zu einem Coil oder einer Spule aufwickelbar, von welchem/r sie dann bei Bedarf zur Weiterverarbeitung abgerollt werden kann.

In einer anderen Ausführungsform ist das Trägermaterial die Zusatzschicht, beispielsweise die Kupferfolie, auf welcher bereits die Lotschicht fixiert bzw. angeordnet ist, wobei diese Kupferfolie später die eigentliche Metallisierung bildet.

Unabhängig davon, ob das Trägermaterial durch die Zusatzschicht gebildet wird oder nicht, erfolgt in einer Ausführungsform ein zweistufiger Walzprozess, umfassend die Schritte:
- erstes Walzen eines Lotmaterials zum Herstellen eines Lotbandes und Aufbringen des Lotbandes auf die zweite Oberfläche der Zusatzschicht bzw. auf ein Trägermaterial;
- zweites Walzen der derart plattierten Zusatzschicht/des derart plattierten Trägermaterials, so dass die Dicke der Lotschicht weniger als 12 µm, insbesondere weniger als 7 µm, erreicht; und
- ggf. Glühen oder Zwischenglühen oder Erwärmen zwischen oder während der Walzschritte, insbesondere des zweiten Walzens.

In einer Ausführungsform wird im ersten Walzschritt eine Dickenreduzierung von vorzugsweise über 40 % bezogen auf die Ausgangsdicke des Lotmaterials durchgeführt. Die sich anschließenden Walzschritte führen zu einer geringeren Dickenreduzierung und dienen der Einstellung der Enddicke. Der Prozess wird so geführt, dass es zu keinem Aufreißen oder Abplatzen der Lotschicht kommt.

In einer Ausführungsform ist das zweistufige Walzverfahren insbesondere noch durch folgenden Schritt gekennzeichnet:
- Leichtes Strecken der plattierten Zusatzschicht bzw. des plattierten Trägermaterials, beispielsweise um etwa 5 - 10 %, beim Walzen.

Dies ermöglicht eine weitere Verbesserung der Verbindung zwischen der Lotschicht und der Zusatzschicht und insbesondere eine weitere Dickenreduzierung. In einer Ausführungsform ist auch ein Walzprozess mit mehr als zwei Stufen, beispielsweise 3, 4, 5, 6, 7 oder noch mehr Stufen vorgesehen. Die mehrstufige Verfahrensführung bringt den Vorteil mit sich, dass in jeder Stufe immer nur eine sehr geringe Dickenreduzierung, ggf. unter Wärmeeinfluss, erfolgen muss.

Die derart plattierte und ggf. gestreckte Zusatzschicht kann dann auf der ersten Oberfläche (bzw. auf einer der ersten Oberflächen) flächig, insbesondere vollflächig, aufgelegt werden. Wurde ein Trägermaterial verwendet, wird dieses in einer Ausführungsform auf der zweiten Oberfläche der Zusatzschicht aufgelegt. Alternativ kann es auch auf der oder auf einer der ersten Oberflächen des Basismaterials angeordnet/aufgelegt werden. Zu beachten ist bei der Anordnung grundsätzlich, dass sich die Reaktionsschicht immer auf der Seite zum Basismaterial hin, also zur Keramik hin, ausbilden muss. Bei Verwendung des Trägermaterials muss dieses ggf. noch entfernt werden. Alternativ kann auf ein Entfernen aber auch verzichtet werden, wenn sichergestellt, ist, dass dadurch das Lötverfahren nicht negativ beeinflusst wird. Insbesondere bei einem zweiseitig mit Lotmaterial beschichteten Trägermaterial muss der Werkstoff für das Trägermaterial so gewählt werden, dass auf ein Entfernen des Trägermaterials verzichtet werden kann.

In einer Ausführungsform ist auch eine Schicht- bzw. Sandwich-Struktur vorgesehen, bei welcher die Trägerfolie auf der zur ersten Oberfläche des Basismaterials zugewandten Seite mit dem Aktivlot bzw. der Aktivlotschicht beschichtet ist, während es auf der gegenüberliegenden Seite mit einem herkömmlichen Lot beschichtet ist, wobei das herkömmliche Lot dahingehend ausgesucht wird, dass mit der Zusatzschicht, also der Metallisierung, eine gute Lötverbindung möglich ist.

In einer Ausführungsform ist auch eine Kombination der vorgenannten Verfahren zum Aufbringen der Lotschicht dergestalt vorgesehen, dass das Aktivmaterial separat auf eine der zu fügenden Oberflächen gebracht wird. Das Aktivelement ist dann also nicht Bestandteil des Lotmaterials, sondern wird separat, beispielsweise in Pulverform, auf eine der zur fügenden Oberflächen gebracht.

Mit der Erfindung wird der Verbrauch von silberhaltigen Loten maßgeblich reduziert, da die bekannten Lotschichtdicken im Allgemeinen im Bereich von 10 bis 30 µm und mehr liegen. Gegenüber dem aus dem Stand der Technik bekannten Verfahren kann 10-20 % an Silber eingespart werden.

Neben den Kostenvorteilen und den bereits erwähnten besseren mechanischen Eigenschaften eines derartigen Verbundmaterials ist zudem die bessere Ätzbarkeit im sogenannten "second etching" zu erwähnen. Bei einer Aluminiumnitrid-Keramik, die sich unter anderem durch eine im Vergleich zur AluminiumoxidKeramik, höhere thermische Leitfähigkeit auszeichnet, bildet die AktivlotKomponente mit dem Aluminiumnitrid eine elektrisch leitende Verbindung, beispielsweise Titannitrid, so dass das für die Strukturierung der Metallisierung notwendige Ätzverfahren wenigstens zweistufig ausgeführt werden muss, und zwar derart, dass in einem ersten Ätzschritt ("first etching") das Strukturieren der Metallisierung zur Erzeugen von Leiterbahnen, Kontaktflächen usw., erfolgt und dann in einem zweiten nachgeschalteten Verfahrensschritt ("second etching") das elektrisch leitende, durch chemische Reaktion der Aktivlotkomponente mit dem Aluminiumnitrid entstandene Material zwischen den Leiterbahnen, Kontaktflächen usw. durch Ätzen entfernt werden muss. Die sehr dünne Lotschicht von unter 7 µm erleichtert hier die Entfernung der Lotschicht.

Die Erfindung umfasst auch ein Verbundmaterial, insbesondere eine Leiterplatte, hergestellt nach dem erfindungsgemäßen Verfahren. Die bezüglich des Herstellungsverfahrens genannten Vorteile und Merkmale gelten analog und entsprechend für das erfindungsgemäße Verbundmaterial, wie auch umgekehrt.

Weitere Vorteile und Merkmale ergeben sich aus der nachfolgenden Beschreibung bevorzugter Ausführungsformen des erfindungsgemäßen Verfahrens zur Herstellung eines Verbundmaterials bzw. des Verbundmaterials mit Bezug auf die beigefügten Figuren. Merkmale der einzelnen Ausführungsformen können dabei im Rahmen der Erfindung miteinander kombiniert werden.

Es zeigen:
- Fig. 1:: eine Ausführungsform eines Verbundmaterials in einer Schnittansicht;
- Fig. 2:: eine Prinzipdarstellung einer Ausführungsform des Verfahrens mit einem zweistufigen Walzprozess.

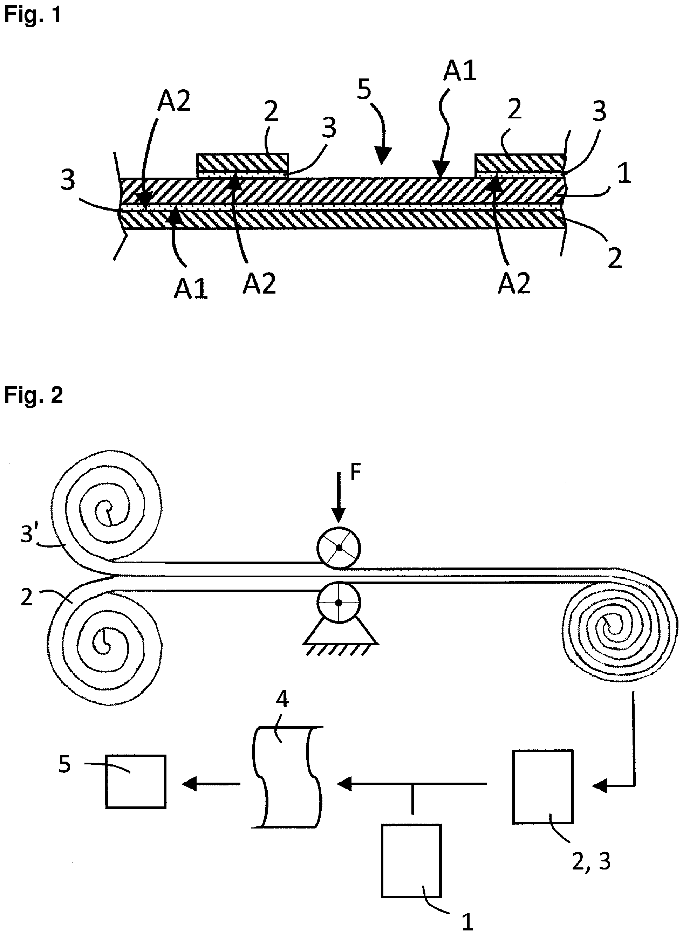

**Fig. 1** zeigt ein Basismaterial 1, welches zu beiden Seiten eine erste Oberfläche A1 aufweist. An den ersten Oberflächen A1 des Basismaterials 1 sind über entsprechende zweite Oberflächen A2 Zusatzschichten 2 über Lotschichten 3 befestigt. In einer Ausführungsform weist das Basismaterial 1 AIN, Si3N4, SiC, Al2O3, ZrO2, ZTA (Zirconia Toughened Aluminum Oxide, Zirconiumdioxid-verstärktes Aluminiumoxid), BeO, TiO2, HPS, HPI und/oder TiOx auf bzw. besteht aus einem oder einer Kombination der vorgenannten Stoffe/Materialien. Die untere Zusatzschicht 2, welche in einer Ausführungsform eine Metallschicht, beispielsweise aus Kupfer, einer Kupferlegierung, Mo, W, Ta, Nb, Ni, Fe, Al, einer Aluminiumlegierung, Stahl und/oder einer Titanlegierung ist, ist ohne eine Strukturierung ausgebildet und dient bevorzugt der Wärmeleitung bzw. der Wärmeabfuhr. Demgegenüber ist die obere Zusatzschicht 2 strukturiert ausgebildet und bildet als sogenannte Aktivschicht Leiterbahnen, Kontaktflächen etc. aus. Durch die äußerst dünne Lotschicht 3, welche weniger als 12 µm, insbesondere weniger als 7 µm beträgt, kann diese Strukturierung besonders einfach, beispielsweise im Rahmen eines zweistufigen Ätzverfahrens, erfolgen.

**Fig. 2** zeigt ein zweistufiges Walzplattierverfahren, bei welchem in der linken Bildhälfte ein gewalztes Lotband 3' und eine Zusatzschicht 2 miteinander verbunden werden, so dass ein Verbund aus einer auf der Zusatzschicht 2 angeordneten Lotschicht 3 entsteht (dieser Schritt ist in Fig. 2 nicht explizit dargestellt). Zu diesem Zeitpunkt weist die Lotschicht 3 noch eine Dicke auf, die oberhalb des Zielwerts von unter 12 µm, insbesondere von unter 7 µm, liegt. Im mittleren Bildteil von Fig. 2 ist ein zweiter Walzschritt skizziert, wobei hier, durch Aufbringen einer Kraft F (und ggf. dem Einsatz von Wärme) und ggf. durch ein leichtes Strecken der mit der Lotschicht 3 plattierten Zusatzschicht 2, um beispielsweise 5 - 10 %, die Verbindung zwischen der Lotschicht 3 und der Zusatzschicht 2 noch weiter verbessert werden kann. Insbesondere können durch das mehrstufige Verfahren sehr geringe Lotschichtdicken erreicht werden. Die derart plattierte Zusatzschicht 2 kann dann aufgewickelt und bei Bedarf verwendet werden. Hierbei wird die plattierte Zusatzschicht 2, 3 auf eine erste Oberfläche des Basismaterials 1 flächig, insbesondere vollflächig, aufgelegt, um dann in einem Ofen 4 zu einem Verbundmaterial 5 verlötet zu werden.

### Bezugszeichenliste

- 1: Basismaterial
- A1: erste Oberfläche
- 2: Zusatzschicht
- A2: zweite Oberfläche
- 3: Lotschicht
- 3': Lotband
- 4: Ofen
- 5: Verbundmaterial

## Patentansprüche

1. Verfahren zur Herstellung eines Verbundmaterials (5), insbesondere einer Leiterplatte,
wobei das Verbundmaterial (5) ein flächiges Basismaterial (1), nämlich eine Keramik, aufweist, an welcher ein- oder beidseitig mittels einer Lotschicht (3) eine Zusatzschicht (2), nämlich eine Metallisierung, angebracht wird, **gekennzeichnet durch**:
- Bereitstellen des Basismaterials (1), wobei das Basismaterial (1) auf mindestens einer Seite eine erste Oberfläche (A1) aufweist;
- Bereitstellen der Zusatzschicht (2) und Anordnen der Lotschicht (3) zwischen einer zweiten Oberfläche (A2) der Zusatzschicht (2) und der ersten Oberfläche (A1) derart, dass beim Auflegen der Zusatzschicht (3) auf die erste Oberfläche (A1) die erste Oberfläche (A1) des Basismaterials (1) flächig mit der Lotschicht (3) bedeckt ist, wobei eine Dicke der Lotschicht (3) zwischen dem Basismaterial (1) und der Zusatzschicht (2) kleiner als 7 µm, ist;
- wobei ein Aufbringen der Lotschicht (3) auf die zweite Oberfläche (A2) der Zusatzschicht (2) durch Walzplattieren erfolgt, mittels
∘ erstes Walzen eines Lotmaterials zum Herstellen eines Lotbandes (3') und Aufbringen des Lotbandes (3') auf die zweite Oberfläche (A2) der Zusatzschicht (2); und
o zweites Walzen der derart plattierten Zusatzschicht (2), so dass die Dicke der Lotschicht (3) weniger als 7 µm erreicht, und
- Erhitzen des Basismaterials (1) und der auf der ersten Oberfläche (A1) angeordneten Zusatzschicht (2) zum zumindest teilweisen Schmelzen der Lotschicht (3) und Verbinden des Basismaterials (1) mit der mindestens einen Zusatzschicht (2).

2. Verfahren nach Anspruch 1,
wobei das Basismaterial AlN, Si3N4, SiC, Al2O3, ZrO2, ZTA (Zirconia Toughened Aluminum Oxide), BeO, TiO2 und/oder TiOx aufweist.

3. Verfahren nach Anspruch 1 oder 2,
wobei die Zusatzschicht Cu, eine Cu-Legierung, Mo, W, Ta, Nb, Ni, Fe, Al, eine Aluminiumlegierung, Stahl und/oder eine Ti-Legierung aufweist.

4. Verfahren nach einem der vorhergehenden Ansprüche,
wobei die Lotschicht (3) eine Aktivlotschicht ist, welche Lotmaterial, insbesondere Ag, Cu, Sn, Zn und/oder In, und Aktivmaterial, insbesondere Ti, Zr, Hf, Cr, Y, Nb und/oder V, aufweist.

5. Verfahren nach einem der vorhergehenden Ansprüche,
wobei die Lotschicht (3) auf einem Trägermaterial bereitgestellt wird.

6. Verfahren nach Anspruch einem der vorhergehenden Ansprüche , **gekennzeichnet durch**:
- Leichtes Strecken der plattierten Zusatzschicht (2), beispielsweise um etwa 5 bis 10 %, beim zweiten Walzen.

## Claims

1. A method for producing a composite material (5), in particular a printed circuit board,
wherein the composite material (5) has a flat base material (1), namely a ceramic, to which an additional layer (2), namely a metallization, is applied on one or both sides by means of a solder layer (3),
**characterized in that**:
- providing the base material (1), the base material (1) having a first surface (A1) on at least one side;
- providing the additional layer (2) and arranging the solder layer (3) between a second surface (A2) of the additional layer (2) and the first surface (A1) in such a way that, when the additional layer (3) is applied to the first surface (A1), the first surface (A1) of the base material (1) is flatly covered with the solder layer (3), wherein a thickness of the solder layer (3) between the base material (1) and the additional layer (2) is smaller than 7 µm;
- wherein the solder layer (3) is applied to the second surface (A2) of the additional layer (2) by roll cladding, by means of
∘ first rolling of a solder material to produce a solder tape (3') and applying the solder tape (3') to the second surface (A2) of the additional layer (2); and
∘ second rolling of the additional layer (2), being cladded in such way, such that the thickness of the solder layer (3) is less than 7 µm, and
- heating the base material (1) and the additional layer (2) arranged on the first surface (A1) for at least partially melting the solder layer (3) and bonding the base material (1) to the at least one additional layer (2).

2. The method according to claim 1,
wherein the base material comprises AIN, Si3N4, SiC, Al2O3, ZrO2, ZTA (Zirconia Toughened Aluminum Oxide), BeO, TiO2 and/or TiOx.

3. The method according to claim 1 or 2,
wherein the additional layer comprises
Cu, a Cu alloy, Mo, W, Ta, Nb, Ni, Fe, Al, an aluminium alloy, steel and/or a Ti alloy.

4. The method according to one of the preceding claims,
wherein the solder layer (3) is an active solder layer comprising solder material, in particular Ag, Cu, Sn, Zn and/or In, and active material, in particular Ti, Zr, Hf, Cr, Y, Nb and/or V.

5. The method according to one of the preceding claims,
wherein the solder layer (3) is provided on a carrier material.

6. The method according to claim one of the preceding claims,**characterized in that**:
- Easy stretching of the clad additional layer (2), for example by about 5 to 10 %, during second rolling.

## Revendications

1. Procédé de fabrication d'un matériau composite (5), en particulier d'une plaquette à circuit imprimé,
dans lequel le matériau composite (5) présente
un matériau de base plat (1), à savoir une céramique, sur lequel une couche supplémentaire (2), à savoir une métallisation, est appliquée sur un ou deux côtés au moyen d'une couche de soudure (3),
**caractérisé par**:
- fournir le matériau de base (1), le matériau de base (1) ayant une première surface (A1) sur au moins un côté ;
- prévoir la couche supplémentaire (2) et disposer la couche de soudure (3) entre une deuxième surface (A2) de la couche supplémentaire (2) et la première surface (A1) de telle sorte que, lorsque la couche supplémentaire (3) est appliquée sur la première surface (A1), la première surface (A1) du matériau de base (1) est couverte à plat avec la couche de soudure (3), une épaisseur de la couche de soudure (3) entre le matériau de base (1) et la couche supplémentaire (2) étant inférieure à 7 µm;
- dans laquelle la couche de soudure (3) est appliquée sur la seconde surface (A2) de la couche supplémentaire (2) au moyen d'un revêtement de rouleau, au moyen de
∘ le premier laminage d'un matériau de soudure pour produire une bande de soudure (3') et l'application de la bande de soudure (3') sur la seconde surface (A2) de la couche supplémentaire (2) ; et
∘ le second laminage de la couche supplémentaire (2) de telle sorte que l'épaisseur de la couche de soudure (3) soit inférieure à 7 µm, et
- Chauffage du matériau de base (1) et de la couche supplémentaire (2) disposée sur la première surface (A1) pour fondre au moins partiellement la couche de soudure (3) et lier le matériau de base (1) à la au moins une couche supplémentaire (2).

2. procédé selon la revendication 1,
dans lequel le matériau de base comprend AlN, Si3N4, SiC, Al2O3, ZrO2, ZTA (Zirconia Toughened Aluminum Oxide), BeO, TiO2 et/ou TiOx.

3. procédé selon la revendication 1 ou 2,
dans lequel la couche supplémentaire comprend
Cu, un alliage de Cu, Mo, W, Ta, Nb, Ni, Fe, Al, un alliage d'aluminium, un acier et/ou un alliage de Ti.

4. Procédé selon l'une des revendications précédentes,
dans lequel la couche de soudure (3) est une couche de soudure active comprenant un matériau de soudure, en particulier Ag, Cu, Sn, Zn et/ou In, et un matériau actif, en particulier Ti, Zr, Hf, Cr, Y, Nb et/ou V.

5. procédé selon l'une des revendications précédentes,
dans lequel la couche de soudure (3) est prévue sur un matériau support.

6. procédure selon la revendication d'une des revendications précédentes , **caractérisé par**:
- Étirage facile de la couche supplémentaire (2), par exemple d'environ 5 à 10 %, lors du deuxième laminage.
